**Europäisches Patentamt**

**European Patent Office**

**Office européen des brevets**

(19)

(11) Veröffentlichungsnummer : **0 367 947 B1**

(12)

# EUROPÄISCHE PATENTSCHRIFT

(45) Veröffentlichungstag der Patentschrift :
**29.11.95 Patentblatt 95/48**

(51) Int. Cl.$^6$ : **H03M 1/30,** H03M 1/20

(21) Anmeldenummer : **89116929.4**

(22) Anmeldetag : **13.09.89**

(54) **Positionsmesseinrichtung mit einer Unterteilungsschaltung.**

(30) Priorität : **11.11.88 DE 3838291**

(43) Veröffentlichungstag der Anmeldung :
**16.05.90 Patentblatt 90/20**

(45) Bekanntmachung des Hinweises auf die
Patenterteilung :
**29.11.95 Patentblatt 95/48**

(84) Benannte Vertragsstaaten :
**AT DE FR GB IT**

(56) Entgegenhaltungen :
**DE-A- 1 945 206**
**DE-A- 2 212 220**
**FR-A- 2 331 772**
**GB-A- 1 141 472**

(73) Patentinhaber : **Dr. Johannes Heidenhain
GmbH
Postfach 12 60
D-83292 Traunreut (DE)**

(72) Erfinder : **Lengenfelder, Hans, Dipl.-Ing. (FH)
Ahamer Strasse 69
D-8260 Mühldorf (DE)**
Erfinder : **Wastlhuber, Roberg, Dipl.-Ing. (FH)
Garchinger-Strasse 20
D-8268 Garching (DE)**

## Beschreibung

Die Erfindung betrifft eine Positionsmeßeinrichtung gemäß dem Oberbegriff des Anspruches 1.

Inkrementale Meßsysteme liefern bekanntlich Impulse, deren Anzahl ein Maß für die lineare Verschiebung oder den Drehwinkel darstellt. Diese Impulse werden in einem Zähler als Wegelemente aufsummiert und als Meßwert numerisch angezeigt oder einer Bearbeitungsmaschine zugeführt.

Die Teilung eines Maßstabes wird von einer Abtasteinheit abgetastet, so daß zwei um 90° gegeneinander phasenverschobene analoge Abtastsignale erzeugt werden. Durch Triggerung dieser sinusförmigen tastsignale erhält man zwei phasenverschobene Impulsfolgen, aus denen durch Flankenauswertung eine Unterteilung einer Teilungsperiode oder einer Abtastsignalperiode mit dem Faktor 4 ermöglicht wird.

Für viele Anwendungen wird ein höherer Unterteilungsfaktor, d.h. ein höheres Auflösungsvermögen gefordert.

Besitzen die beiden analogen Abtastsignale eine genügend gute Sinusform, so lassen sie sich relativ hoch unterteilen. Diese Unterteilung wird auch als Interpolation bezeichnet.

Eine Schaltung zur Interpolation ist aus der Dissertation von Dipl.-Phys. Gerd Ulbers: "Ein Laser-Interferometer zur photoelektrischen Bewegungsfernmessung in beiden Lateralkoordinaten" von 1981 bekannt. Auf den Seiten 63 bis 70 dieser Dissertation ist diese Schaltung beschrieben. Sie basiert auf der Verwendung von zwei direkt dividierenden Analog-Digital-Wandlern. Jeder dieser Analog-Digital-Wandler stellt das Verhältnis von Referenzspannung zur Eingangsspannung als digitales Ergebnis am Ausgang zur Verfügung. Die so durchgeführte Division entspricht der tangens-Bildung der analogen Abtastsignale, wenn die größere Signalamplitude der beiden analogen Abtastsignale an einem Eingang und die kleinere Signalamplitude des anderen Abtastsignals am anderen Eingang des Analog-Digital-Wandlers anliegt. Um dies zu erreichen, sind zwei parallele Analog-Digital-Wandler vorgesehen, die abwechselnd in Abhängigkeit der Signalamplituden der beiden analogen Abtastsignale angesteuert werden. Da die Analog-Digital-Wandler kein negatives Referenzsignal verarbeiten können, wird aus den beiden analogen Abtastsignalen in einem Netzwerk jeweils der Betrag gebildet.

Von den Analog-Digital-Wandlern wird ein 8 Bit-Datenwort erzeugt, das die Adresse für ein PROM darstellt, unter der der entsprechende arcus-tangens-Wert ausgegeben wird. Dieser Wert definiert die Position innerhalb einer viertel Teilungsperiode bzw. Signalperiode der Abtastsignale.

Von Nachteil bei dieser bekannten Schaltung ist der relativ hohe Bauteileaufwand und die abwechselnde Aktivierung zweier Analog-Digital-Wandler.

Eine weitere Positionsmeßeinrichtung mit einer Unterteilungsschaltung ist aus der GB-A- 1 141 472 bekannt. Die Unterteilungsschaltung besteht aus einer Vielzahl von A/D-Wandlern, wobei jedem A/D-Wandler eine Eingangsschaltung vorgeschaltet ist, so daß an einem Eingang nur ein positives und am anderen Eingang nur ein negatives Signal der analogen periodischen Abtastsignale ansteht. Um dies zu erreichen, muß in der Eingangsschaltung zuerst der Oktant der periodischen Abtastsignale bestimmt werden und in Abhängigkeit des Oktanten wird abwechselnd eines der beiden Abtastsignale bzw. invertierten Abtastsignale jeweils einem der beiden Eingänge jedes A/D-Wandlers zugeführt. Die Eingangsschaltung ist aufwendig zu realisieren und durch die laufende Umschaltung wird das Frequenzverhalten der Unterteilungsschaltung negativ beeinflußt.

Der Erfindung liegt die Aufgabe zugrunde, bei einer Positionsmeßeinrichtung mit einer Unterteilungsschaltung den Bauteileaufwand gering zu halten und trotzdem eine hohe Unterteilung zu ermöglichen.

Diese Aufgabe wird von einer Positionsmeßeinrichtung mit den Merkmalen des Anspruches 1 gelöst.

Mit den in den abhängigen Ansprüchen angegebenen Merkmalen kann die Positionsmeßeinrichtung in besonders vorteilhafter Weise ausgestaltet werden.

Der besondere Vorteil der Erfindung liegt darin, daß nur ein Analog-Digital-Wandler benötigt wird und somit ein kostengünstiger Aufbau der Unterteilungsschaltung mit hohem Unterteilungsfaktor realisierbar ist.

Die Erfindung wird nachfolgend an Hand der in der Zeichnung dargestellten Ausführungsbeispiele erläutert.

Es zeigt:

Figur 1  eine schematische Positionsmeßeinrichtung mit einer Unterteilungsschaltung;
Figur 2  einen Analog-Digital-Wandler der Unterteilungsschaltung;
Figur 3  ein Signaldiagramm der Positionsmeßeinrichtung nach Figur 1;
Figur 4  eine weitere Positionsmeßeinrichtung mit einer Unterteilungsschaltung;
Figur 5  eine analoge Interpolationsschaltung der Positionsmeßeinrichtung nach Figur 4:
Figur 6  ein Signaldiagramm.

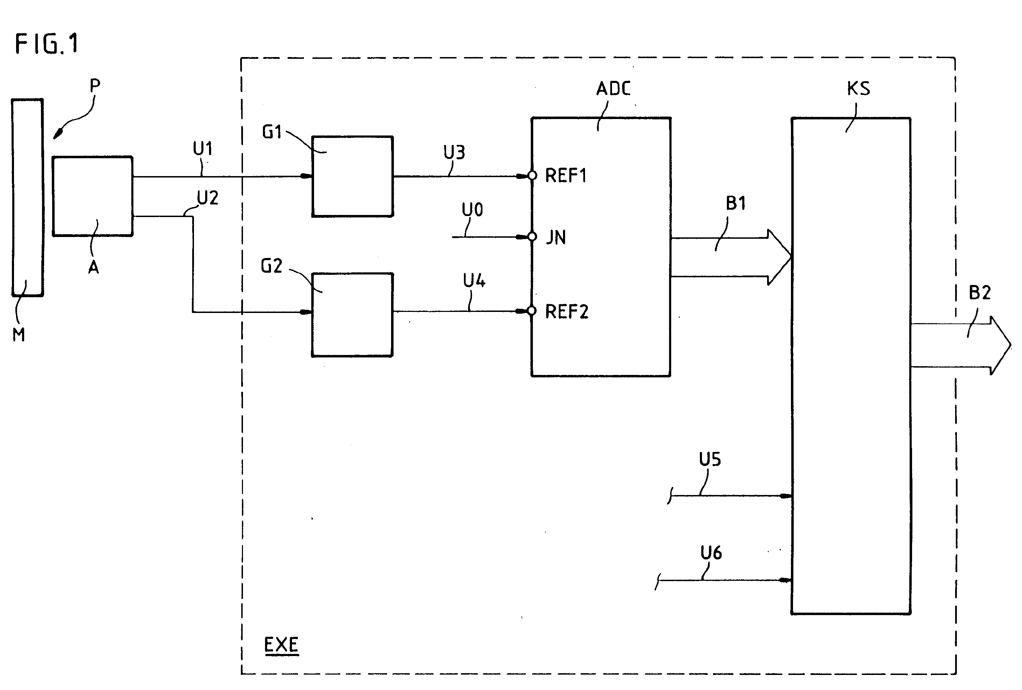

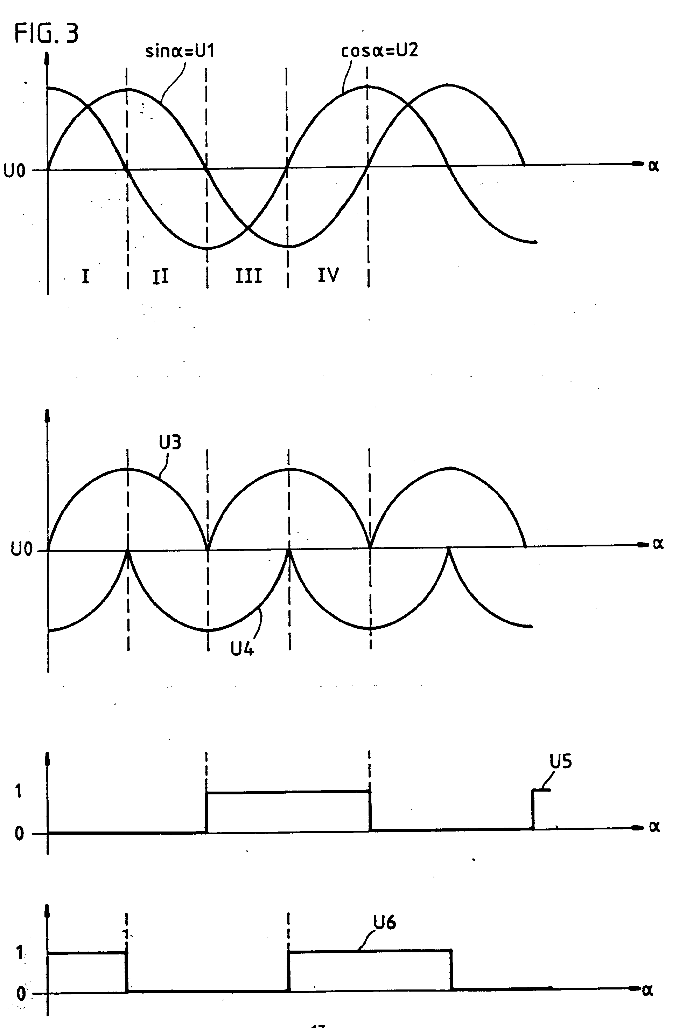

In Figur 1 ist schematisch eine Positionsmeßeinrichtung P mit einer Unterteilungsschaltung EXE gezeigt. Die Positionsmeßeinrichtung P weist eine Maßverkörperung M und eine Abtasteinrichtung A auf. Die Maßverkörperung M und die Abtasteinrichtung A sind jeweils an einem von zwei nicht näher bezeichneten Maschinen-Bauteilen befestigt, deren Relativbewegung gemessen werden soll. Bei Relativbewegungen der Maschinen-Bauteile werden von der Abtasteinrichtung A durch Abtastung der Maßverkörperung M in bekannter Weise analoge sinusförmige Abtastsignale U1 und U2 erzeugt. Zur Erkennung der Bewegungsrichtung sind die Abtastsignale U1, U2 um 90° gegeneinander phasenverschoben (Figur 3):

$$U1 = A * \sin\alpha + UO$$
$$U2 = A * \cos\alpha + UO$$

UO ist dabei jeweils der Gleichspannungsanteil.

Das Eingangssignal am positiven Referenzeingang REF1 eines Analog-Digital-Wandlers ADC muß immer größer sein als das Eingangssignal am negativen Referenzeingang REF2 des Analog-Digital-Wandlers ADC. Weiterhin darf am positiven Referenzeingang REF1 kein negatives Eingangssignal anliegen. Um dies zu erreichen, wird das Abtastsignal U1 einem Vollweggleichrichter G1 zugeführt, der folgendes gleichgerichtete Signal bildet (Figur 3):

$$U3 = U1 \qquad\quad = A*\sin\alpha + UO \quad \text{für } U1 \geq UO$$
$$U3 = (-U1) + 2*UO = -A*\sin\alpha + UO \quad \text{für } U1 < UO$$

Zur Gleichrichtung des analogen Abtastsignals U2 ist ein weiterer Vollweggleichrichter G2 vorgesehen, der aus dem Abtastsignal U2 das folgende gleichgerichtete Signal U4 bildet (Figur 3):

$$U4 = (-U2) + 2*UO = - A*\cos\alpha + UO \quad \text{für } U2 > UO$$
$$U4 = U2 \qquad\quad = A*\cos\alpha + UO \quad \text{für } U2 < UO$$

Der Aufbau derartiger Vollweggleichrichter G1, G2 ist an sich bekannt und beispielsweise in dem Buch: Tietze, Schenk: Halbleiter-Schaltungstechnik, 8. Auflage, Springer-Verlag 1986 auf den Seiten 786 bis 789 beschrieben. Eine weitere Erläuterung der Vollweggleichrichter G1, G2 erübrigt sich daher.

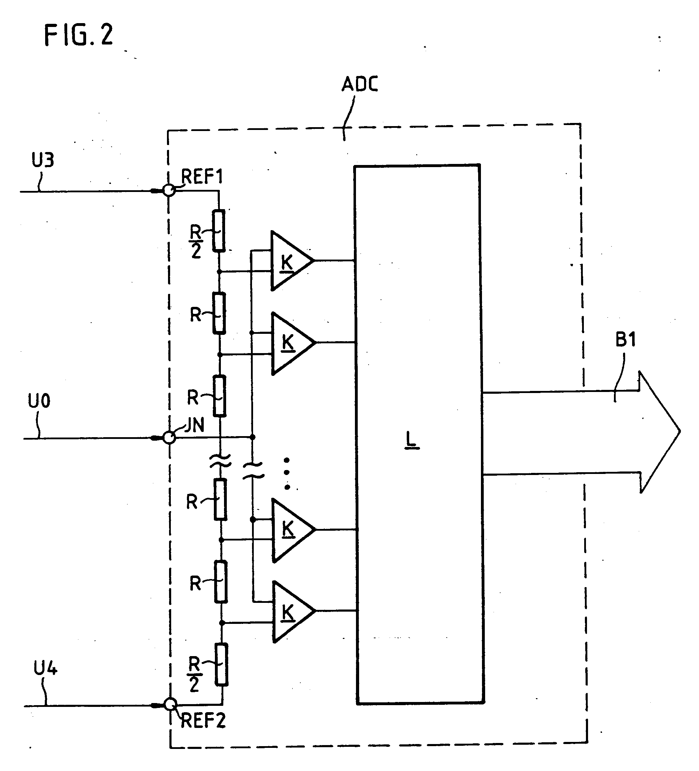

In der folgenden Beschreibung wird der Analog-Digital-Wandler ADC nur als ADC bezeichnet. Das gleichgerichtete Signal U3 wird an den positiven Referenzeingang REF1 des ADC gelegt. Am negativen Referenzeingang REF2 des ADC liegt das gleichgerichtete Signal U4 an. Zwischen den Referenzeingangen REF1 und REF2 des ADC liegt eine Reihe von Widerständen R, die einen Spannungsteiler bilden (Figur 2). Jedem Widerstand R ist ein Komparator K zugeordnet, an dessen einen Eingang die Teilspannungen aus U3 und U4 anliegen und an dessen anderen Eingang der Gleichspannungsanteil UO als Bezugsspannung anliegt. Das Bezugssignal UO steht hierzu dem ADC am Eingang JN zur Verfügung.

Der ADC ist ein N-Bit-Wandler, der aus den gleichgerichteten Signalen U3, U4 und dem Bezugssignal UO ein N-Bit-Binärwort B1 erzeugt, das mit dem Verfahrwinkel $\alpha$ über folgende Funktion zusammenhangt:

$$D = \frac{2^N * (UO - U4)}{U3 - U4}$$

Hierzu ist den Ausgängen der Komparatoren K eine Logikschaltung L zugeordnet.

Allgemein ausgedrückt hängt das vom ADC erzeugte N-Bit-Binärwort B1 von den Eingangssignalen des ADC nach folgender Beziehung ab:

$$D = \frac{2^N * (\text{Signal an JN} - \text{Signal an REF2})}{\text{Signal an REF1} - \text{Signal an REF2}}$$

Jeder ADC hat die Eigenschaft, den Ausgangswert gerundet auszugeben. Demnach erzeugt der ADC ein N-Bit-Binärwort B1, das mit dem Verfahrwinkel $\alpha$ über folgende exakte Funktion zusammenhängt:

$$D = \text{integer} \left( 0,5 + \frac{2^N * (UO - U4)}{U3 - U4} \right)$$

Da diese Art der Rundung bei ADC's jedem Fachmann bekannt ist, wird sie bei den folgenden Ausführungen nicht mehr erwähnt.

Das Bezugssignal UO kann in an sich bekannter Weise durch Verknüpfung der Abtastsignale U1, U2 gewonnen werden, oder aus einer sog. Gleichlichtspur der Positionsmeßeinrichtung P.

Zum besseren Verständnis der nachfolgenden Erläuterung sei angenommen, daß die analogen Abtastsignale U1, U2 symmetrisch zum Bezugssignal UO = 0 Volt sind. Dies kann mittels einer an sich bekannten Verknüpfung mehrerer, gegeneinander jeweils um 90° phasenverschobener Analogsignale erreicht werden. Nachfolgend wird die Übertragungsfunktion D des ADC für die vier Quadranten I bis IV der Abtastsignale U1, U2 (Figur 3) betrachtet:

I. Quadrant:

$$U3 = A*\sin\alpha \atop U4 = -A*\cos\alpha \Bigg\} \quad D = \frac{2^N}{1 + \tan\alpha}$$

II. Quadrant:

$$U3 = A*\sin\alpha \atop U4 = A*\cos\alpha \Bigg\} \quad D = \frac{2^N}{1 - \tan\alpha}$$

III. Quadrant:

$$U3 = -A*\sin\alpha \atop U4 = A*\cos\alpha \Bigg\} \quad D = \frac{2^N}{1 + \tan\alpha}$$

IV. Quadrant:

$$U3 = -A*\sin\alpha \atop U4 = -A*\cos\alpha \Bigg\} \quad D = \frac{2^N}{1 - \tan\alpha}$$

Der Verfahrwinkel $\alpha$, oder allgemein ausgedrückt der Positionswert $\alpha$ innerhalb einer Signalperiode, ist in der Übertragungsfunktion D, die den Ausgangswert des ADC angibt, als trigonometrischer Funktionswert tangens $\alpha$ enthalten. Um einen linearen Zusammenhang zwischen dem Ausgangswert der EXE, der durch das N-Bit-Binärwort B2 bestimmt ist, und dem Verfahrwinkel $\alpha$ herzustellen, ist dem ADC eine Korrektureinrichtung KS nachgeordnet. Diese Korrektureinrichtung KS ist bevorzugt als Tabellenspeicher angelegt, der in binärer Form die Werte 0 bis $2^N$ enthält. Als Korrektureinrichtung KS kann aber auch ein Rechner Verwendung finden, der nach einer vorgegebenen Korrekturfunktion das anstehende N-Bit-Binärwort B1 linearisiert. Diese Berechnung benötigt relativ viel Zeit, so daß bei hohen Relativbewegungen zwischen der Maßverkörperung M und der Abtasteinrichtung A der Tabellenspeicher bevorzugt Verwendung findet. Das N-Bit-Binärwort B1 am Eingang des Tabellenspeichers bestimmt, welche Adresse im Tabellenspeicher angesprochen wird, so daß am Ausgang ein Datenwort B2 anliegt, das unmittelbar von dem Binärwort B1 abhängt und in Kombination mit Codesignalen, die den Quadranten der Abtastsignalperiode bestimmen, die Unterteilungswerte innerhalb einer vollen Abtastsignalperiode repräsentiert.

Die Korrekturfunktion F, nach der das N-Bit-Binärwort B1 am Ausgang des ADC linearisiert wird, hat mit der Übertragungsfunktion D des ADC folgenden Zusammenhang:

$$F = \frac{Q}{360°} * \arctan\left(\frac{2^N}{D} - 1\right) \text{ für } 0 \leq \alpha \leq 90°$$
$$\text{und } 180° \leq \alpha \leq 270°$$

$$F = \frac{Q}{360°} * \arctan\left(1 - \frac{2^N}{D}\right) \text{ für } 90° < \alpha < 180° \qquad \text{und } 270° < \alpha < 360°$$

wobei $Q = 4*2^N$ gewählt wird und den Unterteilungsfaktor einer Abtastsignalperiode bestimmt.

Wenn N=8 gewählt wird, erzeugt der ADC an seinem Ausgang ein 8-Bit-Datenwort B1, das 1/4 der Abtastsignalperiode in 256 Teile unterteilt. Damit die Korrekturfunktion F über die gesamte Abtastsignalperiode eindeutig definiert ist, muß die Korrektureinrichtung KS die Information erhalten, in welchem Quadranten der Abtastsignalperiode sich der momentane Abtastwert (Winkel $\alpha$) befindet. Hierzu werden die beiden analogen Abtastsignale U1, U2 oder die beiden analogen gleichgerichteten Signale U3, U4 verwendet.

In an sich bekannter Weise werden Codesignale U5, U6 gebildet, welche der Korrektureinrichtung KS zur Quadrantenbestimmung zur Verfügung gestellt werden.

4

Durch die Codesignale U5 und U6 werden in der Korrektureinrichtung KS zwei weitere Bits erzeugt, so daß am Ausgang bei N=8 ein 10-Bit-Datenwort B2 ansteht.

Nach der Linearisierung in der Korrektureinrichtung KS steht der Wert am Ausgang der Korrektureinrichtung KS (Unterteilungswert) in einem linearen Zusammenhang zu dem Verfahrwinkel $\alpha$.

Wie bereits erläutert, steht am Ausgang des ADC ein gerundeter Wert der Übertragungsfunktion D als Datenwort B1 an. Bei der Berechnung des Unterteilungswertes mit der Korrekturfunktion F ist ebenfalls eine Rundung erforderlich. Durch diese Rundungen können Fehler entstehen, die dadurch verringert werden, daß in der Korrekturfunktion F der Wert Q kleiner $4*2^N$ gewahlt wird. Der Vorteil dabei ist die höhere Genauigkeit der Linearisierung, als Nachteil dabei ist die Verringerung des möglichen Unterteilungswertes innerhalb einer Abtastperiode zu berücksichtigen. Bei N=8 ist der mögliche Unterteilungswert einer Signalperiode 1024 für Q=1024; wenn aber für Q=800 gewahlt wird, so sinkt der Unterteilungswert auf 800.

Wie bereits erläutert, hängt das N-Bit-Binärwort B1 des ADC von den Eingangssignalen nach folgender Beziehung ab:

$$D = \frac{2^N * (\text{Signal an JN} - \text{Signal an REF2})}{\text{Signal an REF1} - \text{Signal an REF2}}$$

Nachfolgend wird nun der Fall betrachtet, daß die analogen Abtastsignale U1 und U2 vertauscht an den Eingängen der Vollweggleichrichter G1, G2 anliegen. Am Ausgang des Vollweggleichrichters G1 steht folgendes gleichgerichtete Signal zur Verfügung:

$$U3 = A * \cos\alpha + UO \text{ für } U2 \cong UO$$
$$U3 = - A * \cos\alpha + UO \text{ für } U1 < UO$$

Am Ausgang des Vollweggleichrichters G2 steht das Signal U4 an:

$$U4 = - A * \sin\alpha + UO \text{ für } U2 \cong UO$$
$$U4 = A * \sin\alpha + UO \text{ für } U2 < UO$$

Setzt man diese Bedingungen in die allgemein gültige Übertragungsfunktion D ein, so erhält man folgende Beziehungen:

I. und III. Quadrant:

$$D = \frac{2^N}{1 + \cotan\alpha}$$

II. und IV. Quadrant:

$$D = \frac{2^N}{1 - \cotan\alpha}$$

Dementsprechend muß auch die Korrekturfunktion F zur Linearisierung angepaßt werden:

$$F = \frac{Q}{360°} * \text{arc cotan} \left(\frac{2^N}{D} - 1\right) \text{ für } 0 \leq \alpha \leq 90°$$
$$\text{und } 180° \leq \alpha \leq 270°$$

$$F = \frac{Q}{360°} * \text{arc cotan} \left(1 - \frac{2^N}{D}\right) \text{ für } 90° < \alpha < 180°$$
$$\text{und } 270° < \alpha < 360°$$

Die Korrektureinrichtung KS wird hier ebenfalls bevorzugt als Tabellenspeicher ausgeführt, in dem für alle N-Bit-Binärworte B1 des ADC korrigierte Datenworte B2 nach der Korrekturfunktion F abgelegt sind.

In der Figur 2 sind nur die Signale für den Fall gezeigt, bei dem U1=A*sin$\alpha$ + UO und U2=A*cos$\alpha$ + UO ist. Für den zweiten Fall, bei dem U1=A*cos$\alpha$ + UO und U2=A*sin$\alpha$ + UO ist, erübrigt sich wegen der Äquivalenz eine nähere Betrachtung der Signale.

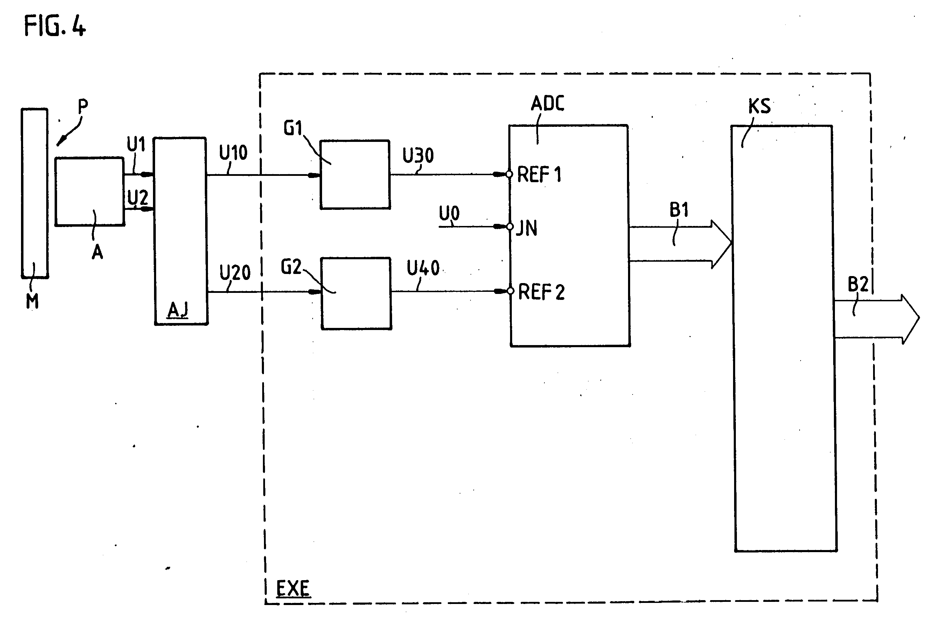

Bei der Ausführung nach Figur 4 ist der Unterteilungsschaltung EXE eine analoge Interpolationsschaltung AJ zugeordnet. Diese analoge Interpolationsschaltung AJ hat die Aufgabe, die Frequenz der Abtastsignale U1, U2 zu erhöhen. Am Ausgang der analogen Interpolationsschaltung AJ stehen folgende Signale an:

$$U10 = A * \sin(V * \alpha) + UO \text{ für } U1 = A * \sin\alpha + UO$$
$$U20 = A * \cos(V * \alpha) + UO \text{ für } U2 = A * \cos\alpha + UO,$$

wobei V den Faktor der Frequenzvervielfachung angibt.

Durch Vollweggleichrichtung der Signale U10, U20 werden die gleichgerichteten Signale U30 und U40 erzeugt, die am ADC anliegen. In die Formel der Übertragungsfunktion D des ADC sind die Signale U30 und U40 einzutragen:

$$D = \frac{2^N * (UO - U40)}{U30 - U40}$$

Der ADC unterteilt eine volle Signalperiode der Abtastsignale U1, U2 in $(4*V*2^N)$ Teile. Das Binärwort B1 am Ausgang des ADC muß daher mit Codesignalen verknüpft werden, die den $(4*V)$-ten Teil einer vollen Signalperiode definieren. Zu diesem Zweck können die gleichgerichteten Signale U30, U40 oder die Abtastsignale U1, U2 bzw. die Signale U10, U20 herangezogen werden. Die Erzeugung von Codesignalen wurde bereits zu Figur 1 ausführlich erläutert.

Als analoge Interpolationsschaltung AJ kann eine bekannte Anordnung, wie sie in der DD-PS 97 336 angegeben ist, Verwendung finden. Es ist weiterhin denkbar, daß die zwei analogen Signale U10, U20 aus einer nicht gezeigten analogen Interpolationsschaltung gebildet werden, an der die Abtastsignale von zwei Abtasteinrichtungen anliegen. So ist es bei Drehgebern besonders vorteilhaft, wenn zwei einander diametral gegenüberliegende Abtasteinrichtungen eingesetzt werden, von denen je ein sin - und ein cos - Signal abnehmbar ist. Durch geeignete Verknüpfung der vier Signale ist eine Frequenzvervielfachung und gleichzeitig die Eliminierung der Exzentrizität zwischen der Winkelteilung und der Drehachse möglich.

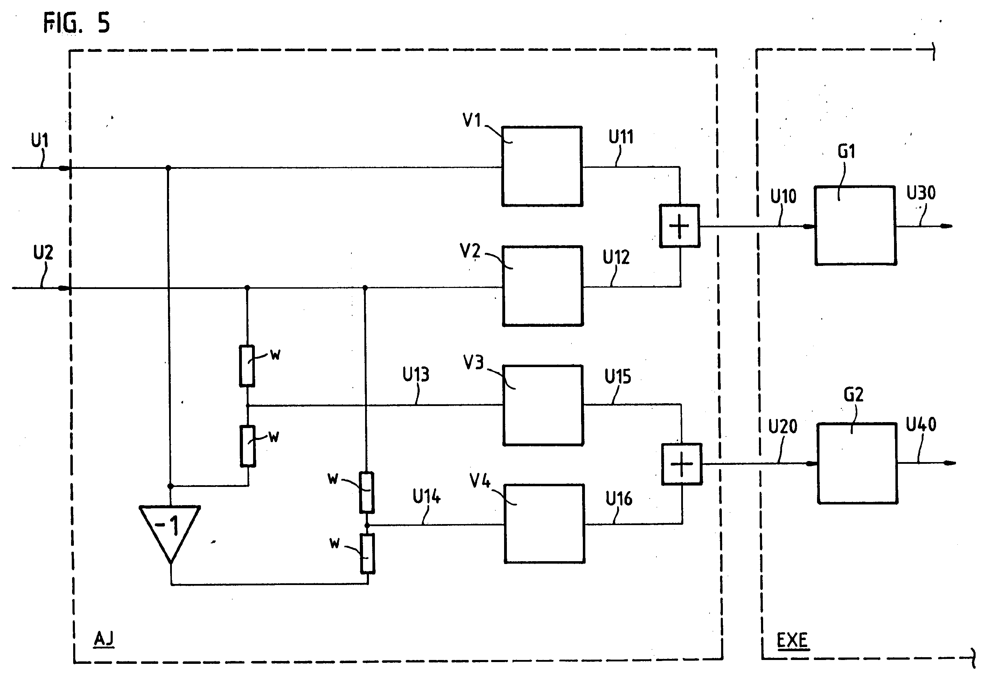

In der Figur 5 ist eine analoge Interpolationsschaltung AJ im Detail gezeigt. Diese analoge Interpolationsschaltung AJ bewirkt nicht nur eine Frequenzvervielfachung, sondern sie hat gleichzeitig die Eigenschaft, einen linearen Zusammenhang zwischen dem Winkel $\alpha$ und der Spannung der Signale U10, U20 herzustellen. Beschrieben wird nachfolgend nur die analoge Interpolationsschaltung AJ mit dem Faktor =2 als Frequenzvervielfachung.

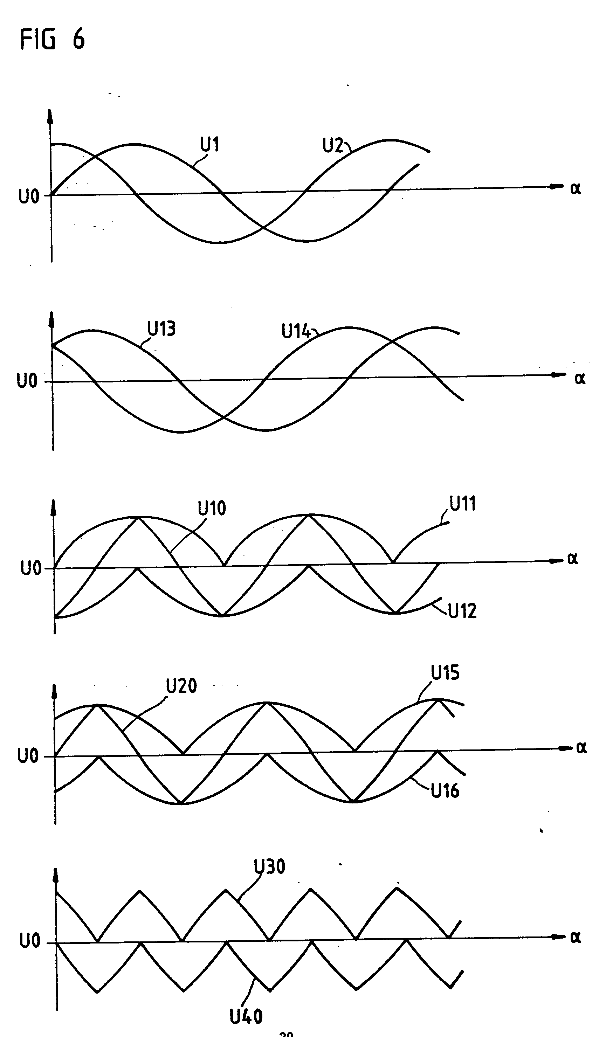

Es sei angenommen, daß die Abtastsignale U1 = A*sin$\alpha$+UO und U2 = A*cos$\alpha$ + UO und UO = OV sind. Das Abtastsignal U1 wird einem Vollweggleichrichter V1 zugeführt, der daraus das gleichgerichtete Signal (U11=$|$A*sin$\alpha|$) bildet. Das Abtastsignal U2 wird einem Vollweggleichrichter V2 zugeführt, an dessen Ausgang das gleichgerichtete Signal (U12 = -$|$A*cos$\alpha|$) ansteht. Beide Signale U11, U12 werden addiert und ergeben das Signal (U10 = $|$A*sin$\alpha|$-$|$-A*cos$\alpha|$). Die Signale zu dem Ausführungsbeispiel nach Figur 5 sind in der Figur 6 gezeigt. Man erkennt, daß das Signal U10 nur noch einen sinusähnlichen Verlauf hat, der einem dreieckförmigen Verlauf sehr nahe kommt.

Zur Erzeugung eines zweiten, gegenüber dem Signal U10 um 90° phasenverschobenen Signals U20 werden aus den beiden Abtastsignalen U1, U2 zuerst ein Signal U13 = A*sin ($\alpha$+45°) + UO und ein Signal U14 = A*cos ($\alpha$+45°) + UO gebildet. Hierzu werden die Abtastsignale U1, U2 den Widerständen W von Spannungsteilern zugeführt.

Das Signal U13 wird dem Vollweggleichrichter V3 zugeführt, der das gleichgerichtete Signal

$$U15 \; = \; |U13| \; \text{bildet.}$$

Das Signal U14 wird dem Vollweggleichrichter V4 zugeführt, an dessen Ausgang das gleichgerichtete Signal

$$U16 \; = \; - |U14| \; \text{ansteht.}$$

Beide Signale U15 und U16 werden addiert und das Summensignal U20 steht der Gleichrichterschaltung G2 der Unterteilungsschaltung EXE zur weiteren Verarbeitung zur Verfügung:

$$U20 \; = \; |U13| \; - |U14|$$

Aus dem Signal U10 bildet die Gleichrichterschal tung G1 der Unterteilungsschaltung EXE das gleichgerichtete Signal:

$$U30 \; = \; ||A * \sin\alpha| \; - |A * \cos\alpha||$$

Die Gleichrichterschaltung G2 bildet aus dem Signal U20 das gleichgerichtete Signal U40.

Das gleichgerichtete Signal U30 wird an den positiven Referenzeingang REF1 des ADC angelegt. Am negativen Referenzeingang REF2 des ADC liegt das gleichgerichtete Signal U40 an. Die Übertragungsfunktion

$$D \; = \; \frac{2^N \; * \; (UO - U40)}{U30 - U40}$$

des ADC ist für jeden Oktanten einer Signalperiode der Abtastsignale U1, U2 separat zu betrachten.

Die Korrekturfunktion F muß ebenfalls in Abhängigkeit des Oktanten aufgestellt werden. Dies erfolgt in ähnlicher Weise wie es bereits zu der Figur 1 beschrieben wurde. Damit die Korrekturfunktion F über die gesamte Abtastsignalperiode eindeutig definiert ist, muß auch in diesem Fall die Korrektureinrichtung KS die Information erhalten, in welchem Oktanten der Abtastsignalperiode sich der momentane Abtastwert (Winkel $\alpha$) befindet.

In der Figur 5 wurde nur eine analoge Interpolationsschaltung AJ mit der Eigenschaft der Frequenzverdopplung gezeigt. Es ist auch möglich, mehrere analoge Interpolationsschaltungen AJ hintereinander anzuordnen, wobei die Signale U10, U20 die Eingangssignale der nächsten Interpolationsschaltung sind. Diese Hintereinanderschaltung hat den Vorteil, daß die Ausgangssignale der letzten analogen Interpolationsschaltung so verformt sind, daß sie annähernd linear verlaufen, d.h., ein annähernd linearer Zusammenhang zwischen den Signalamplituden und dem Verfahrweg (Winkel $\alpha$) besteht.

Bei den bisher beschriebenen Ausführungen kann ein handelsüblicher, relativ preiswerter ADC verwendet werden. Bei diesem ADC sind alle Widerstände R der Widerstandskette identisch. Wenn diese Widerstände R unterschiedlich gewählt werden, d.h. entsprechend dem Verlauf einer trigonometrischen Funktion, dann kann die Korrektureinrichtung KS entfallen. Am Ausgang des ADC stehen dann bereits Werte an, die einen Bruchteil einer Abtastsignalperiode in gleiche Teile unterteilt.

In Figur 1 liegen die Abtastsignale U1, U2 direkt an den Vollweggleichrichtern G1, G2. Wenn die Abtastsignale U1, U2 eine geringe Amplitude aufweisen, können in nicht gezeigter Weise zusätzlich Verstärker zwischen der Abtasteinrichtung A und den Vollweggleichrichtern G1, G2 oder zwischen den Vollweggleichrichtern G1, G2 und dem ADC angeordnet werden. Dies gilt auch für das Ausführungsbeispiel nach Figur 4.

Als ADC wird bevorzugt ein Flashconverter verwendet, der eine schnelle Analog-Digital-Wandlung der analogen Signale U3, U4 oder U30, U40 nach beschriebener Funktion gewährleistet.

Die erfindungsgemäße Unterteilungsschaltung EXE ist bei verschiedenen Positionsmeßeinrichtungen P anwendbar, die analoge ortsperiodische Abtastsignale erzeugen. Je nach Ausbildung der Maßverkörperung spricht man von lichtelektrischen, kapazitiven, magnetischen oder induktiven Meßeinrichtungen. Die Maßverkörperung kann aber auch von Lichtwellen gebildet sein, d.h., daß die Unterteilungsschaltung EXE auch zur Unterteilung von periodischen Signalen bei Interferometern einsetzbar ist.

## Patentansprüche

1.  Positionsmeßeinrichtung (P) mit einer Unterteilungsschaltung (EXE) zur Unterteilung von positionsabhängigen analogen periodischen Abtastsignalen (U1, U2), wobei der Unterteilungsschaltung (EXE) zwei gegeneinander um 90° phasenverschobene analoge periodische Signale (U1, U2; U10, U20) mit gleichem Gleichspannungsanteil (UO) zugeführt werden und am Ausgang der Unterteilungsschaltung (EXE) ein digitales N-Bit-Datenwort (B1; B2) ansteht, daß Zwischenwerte innerhalb einer Signalperiode der Abtastsignale (U1, U2) repräsentiert, dadurch gekennzeichnet, daß die Unterteilungsschaltung (EXE) einen Analog-Digital-Wandler (ADC) enthält, der einen Spannungsteiler (R) und Komparatoren (K) sowie eine Logikschaltung (L) enthält; daß der Spannungsteiler zwischen Referenzeingängen (REF1, REF2) des Analog-Digital-Wandlers liegt; daß an den Komparatoren (K) jeweils der Gleichspannungsanteil (UO) der periodischen Signale (U1, U2; U10, U20) und eine Teilspannung aus dem Spannungsteiler (R) anliegt; daß Gleichrichterschaltungen (G1, G2) vorgesehen sind, die aus den analogen periodischen Signalen (U1, U2; U10, U20) zwei vollweg-gleichgerichtete Signale (U3, U4; U30, U40) ableiten, so daß an einem Referenzeingang (REF1) des Analog-Digital-Wandlers (ADC) das eine vollweg-gleichgerichtete Signal (U3; U30) mit Signalwerten nur größer oder gleich dem Gleichspannungsanteil (UO) eines der analogen periodischen Signale (U1, U2; U10, U20), an dem anderen Referenzeingang (REF2) des Analog-Digital-Wandlers (ADC) das andere vollweg-gleichgerichtete Signal (U4; U40) mit Signalwerten nur kleiner oder gleich dem Gleichspannungsanteil (UO) eines der analogen periodischen Signale (U1, U2; U10, U20) anliegt; und daß am Ausgang des AnalogDigital-Wandlers (ADC) ein mehrstelliges digitales Datenwort (B1) ansteht.

2.  Positionsmeßeinrichtung nach Anspruch 1, dadurch gekennzeichnet, daß der Spannungsteiler eine Reihe von Widerständen (R) enthält, daß an den Komparatoren (K) jeweils der Gleichspannungsanteil (UO) der periodischen Abtastsignale (U1, U2) und eine Teilspannung aus der Reihe der Widerstände (R) anliegt, daß an den Gleichrichterschaltungen (G1, G2) die analogen periodischen Abtastsignale (U1, U2) anliegen, und daß an dem einen Referenzeingang (REF1) des Analog-Digital-Wandlers (ADC), der das eine Ende der Reihe der Widerstände (R) bildet, das gleichgerichtete Signal (U3) mit der Beziehung:

$$U3 = U1 \qquad \text{für } U1 \geqq UO$$
$$U3 = (-U1) + 2 * UO \text{ für } U1 < UO$$

anliegt, und am anderen Referenzeingang (REF2) des Analog-Digital-Wandlers (ADC), der das andere Ende der Reihe der Widerstände (R) bildet, das gleichgerichtete Signal (U4) mit der Beziehung:

$$U4 = (-U2) + 2 * UO \text{ für } U2 \geqq UO$$
$$U4 = U2 \qquad \text{für } U2 < UO$$

anliegt.

3.  Positionsmeßeinrichtung nach Anspruch 2, dadurch gekennzeichnet, daß an dem einen Referenzeingang (REF1) des Analog-Digital-Wandlers (ADC) das gleichgerichtete Signal

$$U3 = A * \sin\alpha + UO \text{ für } U1 \geqq UO$$
$$U3 = -A * \sin\alpha + UO \text{ für } U1 < UO$$

anliegt, wobei das erste Abtastsignal

$$U1 = A * \sin\alpha + UO \text{ ist,}$$

und daß an dem anderen Referenzeingang (REF2) des Analog-Digital-Wandlers (ADC) das gleichgerichtete Signal

$$U4 = -A * \cos\alpha + UO \text{ für } U2 \geqq UO$$
$$U4 = A * \cos\alpha + UO \text{ für } U2 < UO$$

7

anliegt, wobei das zweite Abtastsignal

$$U2 = A * \cos\alpha + UO \text{ ist.}$$

4. Positionsmeßeinrichtung nach Anspruch 3, dadurch gekennzeichnet, daß der Analog-Digital-Wandler (ADC) $2^N$-1 Komparatoren (K) und $2^N$ Widerstände (R) zur Bildung des Spannungsteilers enthält, und daß der Analog-Digital-Wandler (ADC) ein N-Bit-Binärwort (B1) erzeugt, das nach folgender Funktion (von den Eingangswerten (UO, U3, U4) abhängt:

$$D = \frac{2^N * (UO - U4)}{U3 - U4}$$

5. Positionsmeßeinrichtung nach Anspruch 4, dadurch gekennzeichnet, daß dem Analog-Digital-Wandler (ADC) eine Korrektureinrichtung (KS) nachgeordnet ist, die das digitale Datenwort (B2) nach der Funktion:

$$F = \frac{Q}{360°} * \arctan\left(\frac{2^N}{D} - 1\right) \text{ für } 0 \leq \alpha \leq 90° \text{ und } 180° \leq \alpha \leq 270°$$

$$F = \frac{Q}{360°} * \arctan\left(1 - \frac{2^N}{D}\right) \text{ für } 90° < \alpha < 180° \text{ und } 270° < \alpha < 360°$$

bildet, wobei Q den Unterteilungsfaktor einer Signalperiode der Abtastsignale (U1, U2) bestimmt.

6. Positionsmeßeinrichtung nach Anspruch 2, dadurch gekennzeichnet, daß an dem einen Referenzeingang (REF1) des Analog-Digital-Wandlers (ADC) das gleichgerichtete Signal

$$U3 = A * \cos\alpha + UO \text{ für } U1 \geq UO$$
$$U3 = - A * \cos\alpha + UO \text{ für } U1 < UO$$

anliegt, wobei das erste Abtastsignal

$$U1 = A * \cos\alpha + UO \text{ ist,}$$

und daß an dem anderen Referenzeingang (REF2) des Analog-Digital-Wandlers (ADC) das gleichgerichtete Signal

$$U4 = - A\sin\alpha + UO \text{ für } U2 \geq UO$$
$$U4 = A * \sin\alpha + UO \text{ für } U2 < UO$$

anliegt, wobei das zweite Abtastsignal

$$U2 = A * \sin\alpha + UO \text{ ist.}$$

7. Positionsmeßeinrichtung nach Anspruch 6, dadurch gekennzeichnet, daß der Analog-Digital-Wandler (ADC) $2^N$-1 Komparatoren (K) und $2^N$ Widerstände (R) zur Bildung des Spannungsteilers enthält, und daß der Analog-Digital-Wandler (ADC) ein N-Bit-Binärwort (B1) erzeugt, das nach folgender Funktion von den Eingangswerten (UO, U3, U4) abhängt:

$$D = \frac{2^N * (UO - U4)}{U3 - U4}$$

8. Positionsmeßeinrichtung nach Anspruch 7, dadurch gekennzeichnet, daß dem Analog-Digital-Wandler (ADC) eine Korrektureinrichtung (KS) nachgeordnet ist, die das digitale Datenwort (B2) nach der Funktion:

$$F = \frac{Q}{360°} * \text{arc cotan}\left(\frac{2^N}{D} - 1\right) \text{ für } 0° \leq \alpha \leq 90° \text{ und } 180° \leq \alpha \leq 270°$$

$$F = \frac{Q}{360°} * \text{arc cotan}\left(1 - \frac{2^N}{D}\right) \text{ für } 90° < \alpha < 180° \text{ und } 270° < \alpha < 360°$$

bildet, wobei Q den Unterteilungsfaktor einer Signalperiode der Abtastsignale (U1, U2) bestimmt.

9. Positionsmeßeinrichtung nach einem der Ansprüche 3 bis 8, dadurch gekennzeichnet, daß aus den beiden um 90° gegeneinander phasenverschobenen Abtastsignalen (U1, U2) Codesignale (U5, U6) abgeleitet werden, die eine Signalperiode der Abtastsignale (U1, U2) in vier gleiche Abschnitte (I, II, III, IV) unterteilt, die jeweils durch die logischen Zustände der Codesignale (U5, U6) definiert sind.

10. Positionsmeßeinrichtung nach Anspruch 9, dadurch gekennzeichnet, daß die Korrektureinrichtung (KS) mit den Codesignalen (U5, U6) beaufschlagt wird.

11. Positionsmeßeinrichtung nach Anspruch 1, dadurch gekennzeichnet, daß die analogen periodischen Abtastsignale (U1, U2) an einer analogen Interpolationsschaltung (AJ) zur Frequenzvervielfachung anliegen und am Ausgang der analogen Interpolationsschaltung (AJ) die analoge periodische Signale (U10, U20) mit der V-fachen Frequenz der Abtastsignale (U1, U2) anstehen und den Gleichrichterschaltungen (G1, G2) zugeführt werden.

12. Positionsmeßeinrichtung nach Anspruch 11, dadurch gekennzeichnet, daß der Spannungsteiler eine Reihe von Widerständen (R) enthält, daß an den Komparatoren (K) jeweils der Gleichspannungsanteil (UO) der analogen periodischen Signale (U10, U20) und eine Teilspannung aus der Reihe der Widerstände (R) anliegt, daß an den Gleichrichterschaltungen (G1, G2) die analogen periodischen Signale (U10, U20) anliegen, und daß an dem einen Eingang (REF1) des Analog-Digital-Wandlers (ADC), der das eine Ende der Reihe der Widerstände (R) bildet, das gleichgerichtete Signal (U30) mit der Beziehung:

$$U30 = U10 \quad \text{für } U10 \geqq UO$$
$$U30 = (-U10) + 2 * UO \text{ für } U10 < UO$$

anliegt, und am anderen Eingang (REF2) des Analog-Digital-Wandlers (ADC), der das andere Ende der Reihe der Widerstände (R) bildet, das gleichgerichtete Signal (U40) mit der Beziehung:

$$U40 = (-U20) + 2 * UO \text{ für } U20 \geqq UO$$
$$U40 = U20 \quad \text{für } U20 < UO$$

anliegt.

13. Positionsmeßeinrichtung nach Anspruch 11 oder 12, dadurch gekennzeichnet, daß die Abtastsignale

$$U1 = A * \sin\alpha + UO$$

und

$$U2 = A * \cos\alpha + UO$$

der Interpolationsschaltung (AJ) zugeführt werden, die aus diesen Abtastsignalen (U1, U2) die Signale

$$U10 = A * \sin(V * \alpha) + UO$$

und

$$U20 = A * \cos(V * \alpha) + UO$$

bildet, wobei V den Faktor der Frequenzvervielfachung angibt.

14. Positionsmeßeinrichtung nach Anspruch 11, dadurch gekennzeichnet, daß die analoge Interpolationsschaltung (AJ) die Frequenz der Abtastsignale (U1, U2) um den Faktor V erhöht, und daß der Analog-Digital-Wandler (ADC) einen V-ten Teil einer vollen Signalperiode der Abtastsignale (U1, U2) in $4 * 2^N$ Teile unterteilt.

15. Positionsmeßeinrichtung nach Anspruch 14, dadurch gekennzeichnet, daß aus den Abtastsignalen (U1, U2) Codesignale abgeleitet werden, die den 4*V-ten Teil einer vollen Signalperiode der Abtastsignale (U1, U2) bestimmen.

16. Positionsmeßeinrichtung nach Anspruch 15, dadurch gekennzeichnet, daß dem Analog-Digital-Wandler (ADC) eine Korrektureinrichtung (KS) nachgeschaltet ist, an der das N-Bit-Datenwort (B1) des Analog-Digital-Wandlers (ADC) und die Codesignale anliegen, und daß am Ausgang der Korrektureinrichtung (KS) das digitale Datenwort (B2) ansteht.

17. Positionsmeßeinrichtung nach einem der Ansprüche 5, 8 oder 16 dadurch gekennzeichnet, daß die Korrektureinrichtung (KS) ein Tabellenspeicher ist, in dem mehrere Digitalworte (B2) abgelegt sind und das Binärwort (B1) des Analog-Digital-Wandlers (ADC) als Adresse zum Auslesen des Digitalwortes (B2) dient, das am Ausgang des Tabellenspeichers zur Weiterverarbeitung bereitgestellt wird.

## Claims

1. A position measuring device (P) with a subdividing circuit (EXE) for subdividing position-dependent, analog, periodic sensing signals (U1, U2), wherein two analog, periodic signals (U1, U2; U10, U20) which are mutually phase-displaced by 90° and have the same DC component (UO) are applied to the subdividing circuit (EXE), and an N-bit digital data word (B1; B2) is provided at the output of the subdividing circuit (EXE) and represents intermediate values within a signal period of the sensing signals (U1, U2), characterized in that the subdividing circuit (EXE) includes an analog-to-digital converter (ADC), which has a voltage divider (R) and comparators (K) as well as a logic circuit (L); in that the voltage divider lies between reference inputs (REF1, REF2) of the analog-to- digital converter; in that the DC component (UO) of the periodic signals (U1, U2; U10, U20) and a partial voltage from the voltage divider (R) are applied to each of the comparators (K); in that rectifier circuits (G1, G2) are provided and derive two full-wave rectified signals (U3, U4; U30, U40) from the analog, periodic signals (U1, U2; U10, U20), so that there is present on one reference input (REF1) of the analog-to-digital converter (ADC) the one full-wave rectified signal (U3; U30) with signal values which are only greater than or equal to the DC component (UO) of one of the analog, periodic signals (U1, U2; U10, U20) and there is present on the other reference input (REF2) of the analog-to-digital converter (ADC) the other full-wave rectified signal (U4; U40) with signal values which are only smaller than or equal to the DC component (UO) of one of the analog, periodic signals (U1, U2; U10, U20), and in that a multi-digit digital data word (B1) is provided at the output of the analog-to-digital converter (ADC).

2. A position measuring device according to claim 1, characterized in that the voltage divider has a series of resistors (R), in that the DC voltage component (UO) of the periodic sensing signals (U1, U2) and a partial voltage from the series of resistors (R) are applied to each of the comparators (K), in that the analog, periodic signals (U1, U2) are applied to the rectifier circuits (G1, G2), and in that the rectified signal (U3) is applied to the one reference input (REF1) of the analog-to-digital converter (ADC) which forms the one end of the series of resistors (R), in accordance with the relationship:

$$U3 = U1 \qquad \text{for } U1 \geq UO$$
$$U3 = (-U1) + 2 * UO \qquad \text{for } U1 < UO$$

and the rectified signal (U4) is applied to the other reference input (REF2) of the analog-to-digital converter (ADC), which forms the other end of the series of resistors (R), in accordance with the relationship:

$$U4 = (-U2) + 2 * UO \qquad \text{for } U2 \geq UO$$
$$U4 = U2 \qquad \text{for } U2 < UO.$$

3. A position measuring device according to claim 2, characterized in that the rectified signal

$$U3 = A * \sin\alpha + UO \qquad \text{for } U1 \geq UO$$
$$U3 = -A * \sin\alpha + UO \qquad \text{for } U1 < UO$$

is applied to the one reference input (REF1) of the analog-to-digital converter (ADC), where the first sensing signal is

$$U1 = A * \sin\alpha + UO,$$

and in that the rectified signal

$$U4 = -A * \cos\alpha + UO \qquad \text{for } U2 \geq UO$$
$$U4 = A * \cos\alpha + UO \qquad \text{for } U2 < UO$$

is applied to the other reference input (REF2) of the analog-to-digital converter (ADC), where the second sensing signal is

$$U2 = A * \cos\alpha + UO.$$

4. A position measuring device according to claim 3, characterized in that the analog-to-digital converter (ADC) comprises $2^N - 1$ comparators (K) and $2^N$ resistors (R) for forming the voltage divider, and in that the analog-to-digital converter (ADC) generates an N-bit binary word (B1) which depends on the input values (UO, U3, U4) in accordance with the following function:

$$D = \frac{2^N * (UO - U4)}{U3 - U4}$$

5. A position measuring device according to claim 4, characterized in that a correction device (KS) is associated with the analog-to-digital converter (ADC) and forms the digital data word (B2) according to the function:

$$F = \frac{Q}{360°} * \arctan(\frac{2^N}{D} - 1) \text{ for } 0 \leq \alpha \leq 90° \text{ and } 180° \leq \alpha \leq 270°$$

$$F = \frac{Q}{360°} * \arctan(1 - \frac{2^N}{D}) \text{ for } 90° < \alpha < 180° \text{ and } 270° < \alpha < 360°$$

where Q determines the subdivision factor of a signal period of the sensing signals (U1, U2).

6. A position measuring device according to claim 2, characterized in that the rectified signal

$$U3 = A * \cos\alpha + UO \qquad \text{for } U1 \geq UO$$
$$U3 = -A * \cos\alpha + UO \qquad \text{for } U1 < UO$$

is applied to the one reference input (REF1) of the analog-to-digital converter (ADC), where the first sensing signal is

$$U1 = A * \cos\alpha + UO$$

and the rectified signal

$$U4 = -A * \sin\alpha + UO \qquad \text{for } U2 \geqq UO$$
$$U4 = A * \sin\alpha + UO \qquad \text{for } U2 < UO$$

is applied to the other reference input (REF2) of the analog-to-digital converter (ADC), where the second sensing signal is

$$U2 = A * \sin\alpha + UO.$$

7. A position measuring device according to claim 6, characterized in that the analog-to-digital converter (ADC) comprises $2^N - 1$ comparators (K) and $2^N$ resistors (R) for forming the voltage divider, and in that the analog-to-digital converter (ADC) generates an N-bit binary word (B1) which depends on the input values (UO, U3, U4) in accordance with the following function:

$$D = \frac{2^N(UO - U4)}{U3 - U4}$$

8. A position measuring device according to claim 7, characterized in that a correction device (KS) is associated with the analog-to-digital converter (ADC) and forms the digital data word (B2) according to the function:

$$F = \frac{Q}{360°} * \text{arc } cotan(\frac{2^N}{D} - 1) \text{ for } 0\leqq\alpha\leqq90° \text{ and } 180°\leqq\alpha\leqq270°$$

$$F = \frac{Q}{360°} * \text{arc } cotan(1 - \frac{2^N}{D}) \text{ for } 90°<\alpha<180° \text{ and } 270°<\alpha<360°$$

where Q determines the subdivision factor of a signal period of the sensing signals (U1, U2).

9. A position measuring device according to any of claims 3 to 8, characterized in that code signals (U5, U6) are derived from the two sensing signals (U1, U2) mutually phase-displaced by 90°, which divide a signal period of the sensing signals (U1, U2) into four equal sections (I, II, III, IV), each defined by the logical states of the code signals (U5, U6).

10. A position measuring device according to claim 9, characterized in that the correcting device (KS) is responsive to the code signals (U5, U6).

11. A position measuring device according to claim 1, characterized in that the analog, periodic signals (U1, U2) are applied to an analog interpolation circuit (AJ) for frequency multiplication thereof and the analog, periodic signals (U10, U20) with the V-fold frequency of the sensing signals (U1, U2) appear at the output of the analog interpolation circuit (AJ) and are applied to the rectifier devices (G1, G2).

12. A position measuring device according to claim 11, characterized in that the voltage divider has a series of resistors (R), in that the DC voltage component (UO) of the periodic sensing signals (U10, U20) and a partial voltage from the series of resistors (R) are applied to each of the comparators (K), in that the analog, periodic signals (U10, U20) are applied to the rectifier circuits (G1, G2), and in that the rectified signal (U30) is applied to the one input (REF1) of the analog-to-digital converter (ADC) which forms the one end of the series of resistors (R), in accordance with the relationship:

$$U30 = U10 \qquad \text{for } U10 \geqq UO$$
$$U30 = (-U10) + 2 * UO \qquad \text{for } U10 < UO$$

and the rectified signal (U40) is applied to the other reference input (REF2) of the analog-to-digital converter (ADC), which forms the other end of the series of resistors (R), in accordance with the relationship:

$$U40 = (-U20) + 2 * UO \qquad \text{for } U20 \geqq UO$$
$$U40 = U20 \qquad \text{for } U20 < UO.$$

13. A position measuring device according to claim 11 or 12, characterized in that the sensing signals

$$U1 = A * \sin\alpha + UO$$

and

$$U2 = A * \cos\alpha + UO$$

are applied to the interpolation circuit (AJ), which forms from these sensing signals (U1, U2) the signals

$$U10 = A * \sin(V * \alpha) + UO$$

and

$$U20 = A * \cos(V * \alpha) + UO$$

where V denotes the frequency multiplication factor.

14. A position measuring device according to claim 11, characterized in that the analog interpolation circuit (AJ) increases the frequency of the sensing signals (U1, U2) by the factor V and in that the analog-to-digital converter (ADC) subdivides a Vth part of a complete signal period of the sensing signals (U1, U2) into $4*2^N$ parts.

15. A position measuring device according to claim 14, characterized in that code signals are derived from the sensing signals (U1, U2) and determine the 4∗Vth part of a complete signal period of the sensing signals (U1, U2).

16. A position measuring device according to claim 15, characterized in that a correction device (KS) is associated with the analog-to-digital converter (ADC) and the N-bit data word (B1) of the analog-to-digital converter (ADC) and the code signals are applied thereto, and in that the digital data word (B2) appears at the output of the correction device (KS).

17. A position measuring device according to any of claims 5, 8 and 16, characterized in that the correction device (KS) is a memory table, in which a plurality of digital words (B2) are held and the binary word (B1) of the analog-to-digital converter (ADC) serves as an address for reading out the digital word (B2), which is provided at the output of the memory table for further processing.

**Revendications**

1. Dispositif (P) de mesure de position comportant un circuit diviseur (EXE) pour diviser des signaux (U1, U2) de lecture périodiques analogiques dépendant de la position, le circuit diviseur (EXE) recevant deux signaux (U1, U2; U10, U20) périodiques analogiques mutuellement déphasés de 90°, de même tension continue et un mot (B 1, B2) numérique à N bits étant délivré à la sortie du circuit diviseur (EXE), lequel mot représente des valeurs intermédiaires à l'intérieur d'une période des signaux de lecture (U1, U2), caractérisé par le fait que le circuit diviseur (EXE) comporte un convertisseur analogique - numérique (ADC) qui comprend un diviseur de tension (R) et des comparateurs (K) ainsi qu'un circuit logique (L), par le fait que le diviseur de tension est placé entre les entrées de référence (REF1, REF2) du convertisseur analogique - numérique, par le fait que l'on applique aux comparateurs (K) la tension continue (UO) des signaux périodiques (U1, U2) et une tension partielle provenant du diviseur de tension (R), par le fait qu'il est prévu des circuits redresseurs (G1, G2) qui forment à partir des signaux (U1, U2; U10, U20) périodiques analogiques deux signaux (U3, U4; U30, U40) redressés pleine onde de manière à obtenir à une entrée de référence (REF1) du convertisseur analogique - numérique (ADC), l'un (U3, U30) des signaux redressés pleine onde avec des valeurs de signal exclusivement supérieures ou égales à la tension continue (UO) de l'un des signaux (U1, U2; U10, U20) périodiques analogiques et, à l'autre entrée de référence (REF2) du convertisseur analogique - numérique (ADC), l'autre (U4, U40) signal redressé pleine onde avec des valeurs de signal exclusivement inférieures ou égales à la tension continue (UO) de l'un des signaux (U1, U2; U10, U20) périodiques analogiques et par le fait que l'on obtient à la sortie du convertisseur analogique - numérique (ADC) un mot (B1) numérique à plusieurs positions .

2. Dispositif de mesure de position selon la revendication 1, caractérisé par le fait que le diviseur de tension comprend une série de résistances (R), que l'on applique à chacun des comparateurs (K) la tension continue (UO) des signaux (U1, U2) périodiques de lecture et une tension partielle provenant de la série de résistances (R), par le fait que l'on applique les signaux (U1, U2) périodiques analogiques de lecture aux circuits redresseurs (G1, G2) et par le fait que l'on applique, à l'une des des entrées de référence (REF1) du convertisseur analogique - numérique (ADC) qui constitue l'une des extrémités de la série de résistances (R), le signal (U3) redressé conformément à la relation

$$U3 = U1 \qquad \text{pour } U1 \geqq U0$$
$$U3 = (-U1) + 2*U0 \qquad \text{pour } U1 < U0$$

et, à l'autre entrée de référencè (REF2) du convertisseur analogique - numérique (ADC) qui constitue l'autre extrémité de la série de résistances (R), le signal (U4) conformément à la relation

$$U4 = (-U2) + 2*U0 \qquad \text{pour } U2 \geqq U0$$
$$U4 = U2 \qquad \text{pour } U2 < U0$$

3. Dispositif de mesure de position selon la revendication 2, caractérisé par le fait que l'on applique à l'une des entrées de référence (REF1) du convertisseur analogique - numérique (ADC) le signal redressé

$$U3 = A * \sin \alpha + U0 \qquad \text{pour } U1 \geqq U0$$
$$U3 = -A * \sin \alpha + U0 \qquad \text{pour } U1 < U0,$$

le premier signal de lecture étant

$$U3 = A * \sin \alpha + U0$$

et, à l'autre entrée de référence (REF2) du convertisseur analogique - numérique (ADC), le signal redressé

$$U4 = -A * \cos \alpha + U0 \qquad \text{pour } U2 \geqq U0$$
$$U4 = A * \cos \alpha + U0 \qquad \text{pour } U2 < U0$$

le second signal de lecture étant

$$U2 = A * \cos \alpha + U0.$$

**4.** Dispositif de mesure de position selon la revendication 3, caractérisé par le fait que le convertisseur analogique - numérique (ADC) comprend $2^N - 1$ comparateurs (K) et $2^N$ résistances (R) qui forment le diviseur de tension et par le fait que le convertisseur analogique - numérique (ADC) génère un mot binaire (B1) à N bits qui dépend des valeurs d'entrée (UO, U3, U4) conformément à la relation suivante

$$D = \frac{2^N * (U0 - U4)}{U3 - U4}$$

**5.** Dispositif de mesure de position selon la revendication 4, caractérisé par le fait qu'un dispositif de correction (KS) est placé derrière le convertisseur analogique - numérique (ADC), lequel dispositif forme le mot (B2) numérique conformément à la relation

$$F = \frac{Q}{360°} * \arctan\left(\frac{2^N}{D} - 1\right) \qquad \text{pour } 0° \leqq \alpha \leqq 90° \text{ et } 180° \leqq \alpha \leqq 270°$$

$$F = \frac{Q}{360°} * \arctan\left(1 - \frac{2^N}{D}\right) \qquad \text{pour } 90° < \alpha < 180° \text{ et } 270° < \alpha < 360°$$

**6.** Dispositif de mesure de position selon la revendication 2, caractérisé par le fait que l'on applique à l'une des entrées de référence (REF1) du convertisseur analogique - numérique (ADC) le signal redressé

$$U3 = A * \cos \alpha + U0 \qquad \text{pour } U1 \geqq U0$$
$$U3 = -A * \cos \alpha + U0 \qquad \text{pour } U1 < U0,$$

le premier signal de lecture étant

$$U1 = A * \cos \alpha + U0$$

et par le fait que l'on applique à l'autre entrée de référence (REF2) du convertisseur analogique - numérique (ADC) le signal redressé

$$U4 = -A * \sin \alpha + U0 \text{ pour } U2 \geqq U0$$
$$U4 = A * \sin \alpha + U0 \text{ pour } U2 < U0$$

le second signal de lecture étant

$$U23 = A * \sin \alpha + U0.$$

**7.** Dispositif de mesure de position selon la revendication 6, caractérisé par le fait que le convertisseur analogique - numérique (ADC) comprend $2^N - 1$ comparateurs (K) et $2^N$ résistances (R) pour former le diviseur de tension et par le fait que le convertisseur analogique - numérique (ADC) génère un mot (B1) binaire à N bits qui dépend des valeurs d'entrée (U0, U3, U4) conformément à la relation suivante

$$D = \frac{2^N * (U0 - U4)}{U3 - U4}$$

**8.** Dispositif de mesure de position selon la revendication 7, caractérisé par le fait qu'un dispositif de correction (KS) est placé derrière le convertisseur analogique - numérique (ADC), lequel dispositif forme le mot (B2) numérique conformément à la relation

$$F = \frac{Q}{360°} * \text{arccotan}\left(\frac{2^N}{D} - 1\right) \qquad \text{pour } 0° \leqq \alpha \leqq 90° \text{ et } 180° \leqq \alpha \leqq 270°$$

$$F = \frac{Q}{360°} * \text{arccotan}\left(1 - \frac{2^N}{D}\right) \qquad \text{pour } 90° < \alpha < 180° \text{ et } 270° < \alpha < 360°,$$

Q déterminant le facteur de division d'une période des signaux (U 1, U2) de lecture.

**9.** Dispositif de mesure de position selon l'une des revendications 3 à 8, caractérisé par le fait que l'on tire des deux signaux de lecture (U1, U2), mutuellement déphasés de 90°, des signaux de code (U5, U6) qui divisent une période des signaux de lecture (U1, U2) en quatre sections (I, II, III, IV) identiques qui sont définies chacune par les états logiques des signaux de code (U5, U6).

10. Dispositif de mesure de position selon la revendication 9, caractérisé par le fait que l'on applique les signaux de code (U5, U6) au dispositif de correction (KS).

11. Dispositif de mesure de position selon la revendication 1, caractérisé par le fait que l'on applique les signaux de lecture (U1, U2) périodiques analogiques à un circuit (AJ) analogique d'interpolation aux fins de multiplier la fréquence et que l'on obtient à la sortie du circuit (AJ) analogique d'interpolation des signaux (U10, U20) analogiques périodiques avec un multiple de la fréquence, signaux qui sont appliqués à des circuits (G1, G2) redresseurs.

12. Dispositif de mesure de position selon la revendication 11, caractérisé par le fait que le diviseur de tension comprend une série de résistances (R), par le fait que l'on applique chaque fois aux comparateurs (K) la fraction de tension continue (UO) des signaux (U10, U20) périodiques analogiques et une tension partielle provenant de la série de résistances (R), par le fait que l'on applique aux circuits redresseurs (G1, G2) les signaux (U10, U20) périodiques analogiques et par le fait que l'on applique à l'une des entrées de référence (REF1) du convertisseur analogique - numérique (ADC) qui constitue l'une des extrémités de la série de résistances (R) le signal redressé (U30) conformément à la relation
$$U30 = U10 \qquad \text{pour } U10 \geqq U0$$
$$U30 = (-U10) + 2 * U0 \qquad \text{pour } U10 < U0,$$
et à l'autre entrée de référence (REF2) du convertisseur analogique - numérique (ADC) qui constitue l'autre extrémité de la série de résistances (R) le signal redressé (U40) conformément à la relation
$$U40 = (-U20) + 2 * U0 \qquad \text{pour } U20 \geqq U0$$
$$U40 = U20 \qquad \text{pour } U20 < U0.$$

13. Dispositif de mesure de position selon la revendication 11 ou la revendication 12, caractérisé par le fait que l'on amène les signaux
$$U1 = A * \sin \alpha + U0$$
et
$$U2 = A * \cos \alpha + U0$$
aux circuits d'interpolation (AJ) qui forme à partir desdits signaux de lecture (U1, U2), les signaux
$$U10 = A * \sin (V * \alpha) + U0$$
et
$$U20 = A * \cos (V * \alpha) + U0,$$
V indiquant le facteur de multiplication de la fréquence.

14. Dispositif de mesure de position selon la revendication 11, caractérisé par le fait que le circuit (AJ) analogique d'interpolation élève du facteur V la fréquence des signaux de lecture (U1, U2) et par le fait que le convertisseur analogique - numérique (ADC) divise une $V^{\text{ème}}$ fraction d'une période complète des signaux de lecture (U1, U2) en $4 * 2^N$ fractions.

15. Dispositif de mesure de position selon la revendication 14, caractérisé par le fait que l'on forme à partir des signaux de lecture (U1, U2) des signaux de code qui déterminent la $V^{\text{ème}}$ fraction d'une période complète des signaux de lecture (U1, U2).

16. Dispositif de mesure de position selon la revendication 15, caractérisé par le fait qu'un dispositif de correction (KS) est placé derrière le convertisseur analogique - numérique (ADC), dispositif auquel on applique le mot (B1) à N bits du convertisseur analogique - numérique (ADC) et les signaux de code et par le fait que l'on recueille à la sortie du dispositif de correction (KS) le mot (B2) numérique.

17. Dispositif de mesure de position selon l'une des revendications 5, 8, ou 16, caractérisé par le fait que le dispositif de correction (KS) est une mémoire à tables dans laquelle plusieurs mots (B2) numériques sont mémorisés et le mot binaire (B1) du convertisseur analogique - numérique (ADC) sert d'adresse pour lire le mot numérique (B2) qui est recueilli à la sortie de la mémoire à tables, à des fins de traitement.

# FIG.1

EP 0 367 947 B1

FIG.2

FIG. 3

sinα=U1     cosα=U2

U0

I | II | III | IV

U3

U0     α

U4

U5

1

0     α

U6

1

0     α

FIG. 4

EP 0 367 947 B1

# FIG. 5

EP 0 367 947 B1

FIG 6